(19)

Europäisches
Patentamt
European
Patent Office
Office européen
des brevets

(11) **EP 2 651 034 B1**

(12) **EUROPEAN PATENT SPECIFICATION**

(45) Date of publication and mention
of the grant of the patent:
**06.08.2014  Bulletin 2014/32**

(51) Int Cl.:
*H03K 5/08* *(2006.01)*        *G01R 13/02* *(2006.01)*

(21) Application number: **12163978.5**

(22) Date of filing: **12.04.2012**

(54) **Method for determining a trigger level**

Verfahren zur Bestimmung eines Auslösepegels

Procédé pour déterminer un niveau de déclenchement

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**16.10.2013  Bulletin 2013/42**

(73) Proprietor: **Siemens Aktiengesellschaft
80333 München (DE)**

(72) Inventors:
 • **Bako, Dr. Tamas
  1132 Budapest (HU)**

 • **Borger, Thomas
  64846 Klein-Zimmern (DE)**
 • **Ladanyi, Gergo
  3524 Miskolc (HU)**
 • **Szigethy, Tamas
  1165 Budapest (HU)**

(56) References cited:
**EP-A2- 0 278 637     EP-A2- 0 349 328
US-A- 4 743 844**

**Description**

The invention concerns a method for determining a trigger level for a periodic analog signal in a digital signal processing system.

Digital signal processing (DSP) is concerned with the representation of discrete time, discrete frequency, or other discrete domain signals by a sequence of numbers or symbols and the processing of these signals. The goal of DSP is usually to measure, filter and/or compress continuous real-world analog signals. The first step is usually to convert the signal from an analog to a digital form, by sampling and then digitizing it using an analog-to-digital converter (ADC), which turns the analog signal into a stream of numbers.

The main applications of DSP are audio signal processing, audio compression, digital image processing, video compression, speech processing, speech recognition, digital communications, RADAR, SONAR, seismology and biomedicine. Specific examples are speech compression and transmission in digital mobile phones, room correction of sound in hi-fi and sound reinforcement applications, weather forecasting, economic forecasting, seismic data processing, analysis and control of industrial processes, medical imaging such as CAT scans and MRI, MP3 compression, computer graphics, image manipulation, hi-fi loudspeaker crossovers and equalization, and audio effects for use with electric guitar amplifiers.

DSP often requires accurate pulse-based measurements in connection with periodic analog signals. Here, an analog pulse signal is measured by determining a trigger level and creating a digital output each time when the analog signal level crosses the trigger level in a predetermined direction (rising or falling). Due to natural fluctuations of the analog signal, jitter will occur. Jitter is the undesired deviation from true periodicity of the periodic signal.

Usually, determination of trigger level consists of determination of the maximum and minimum levels of the input signal, then using the half point between minimum and maximum. Sometimes this method is not proper, e.g. when additional, lower amplitude peaks can appear in the trigger signal due to reflections. An example can be seen in prior art document US 4743844.

Therefore, the problem that the invention wants to solve is to provide a method for determining a trigger level in order to reduce output jitter as much as possible and avoid false trigger events.

This problem is inventively solved by a method comprising the steps of:

-   measuring the minimum and maximum values of the signal in a predetermined time,
-   defining a plurality of potential trigger values between the minimum and maximum values,
-   assigning to the respective potential trigger value a jitter value characteristic for the jitter created by processing the signal with the potential trigger value, and
-   determining the optimal trigger level based on the lowest jitter value.

The invention is based on the consideration that output jitter is highly dependent on the trigger level choice for processing of the signal. Thus, the trigger level should be carefully chosen from a plurality of potential trigger levels. These trigger levels should be distributed between the minimum and maximum levels of the analog signal that has been measured for a predetermined time in order to have a broad range of potential trigger levels. To find the best trigger level, the jitter created by processing the signal with a number of the potential trigger levels is evaluated. The evaluation and possible further manipulations result in a jitter value characteristic for the jitter. Then, the optimal trigger level is determined based on the lowest jitter value.

Advantageously, the predetermined time for measuring the analog signal is longer than the period of the signal. This ensures that the measurement will indeed cover the global minimum and maximum of the signal and thus a proper choice of potential trigger values.

Furthermore, the potential trigger values are advantageously evenly spaced. This ensures a broad range of different trigger values for the choice.

Another problem regarding trigger levels occurs when the analog signal strength changes. With simple methods, small changes in the amplitude can change the trigger level or the trigger-based detection can fail due to big changes in the analog signal. Therefore, the trigger level must not always be adjusted, because this can produce jitter on phase measurements based on trigger pulses. However, at strong signal changes the trigger level should be changed, otherwise trigger detection can fail. This problem is solved by advantageously interrupting the execution of the method as described above if the difference of the measured minimum and maximum values of the signal differ from the minimum and maximum values measured during a previous execution of the method by less than a predetermined value.

Determination of the jitter level of a given potential trigger level can be done by various ways. Advantageously, the jitter created by processing the signal is determined by means of a linear regression over a plurality of periods of the signal. This ensures a reliable assessment of the jitter created by a certain trigger level. Advantageously, the linear regression should be extended to 5 or more periods of the signal.

To improve the determination of the optimal trigger level, the jitter values measured in a first step can be further manipulated during assignment of the jitter value to a certain trigger level. Advantageously, assigning a jitter value includes taking a sliding average over a plurality of trigger values. At fine trigger level resolution this method can help to keep distance from trigger parts where the jitter suddenly increases. However, when the trigger level resolution is rough (e.g. only 5 levels) this step may be unnecessary.

Furthermore, assigning a jitter value advantageously includes replacing a measured value with a predetermined threshold value. If the jitter at a given trigger band is lower than this value, then it is accepted as 'very good jitter level', regardless to its exact value and replaced by the threshold level. This means that in the following procedures, these low jitter levels will be handled uniformly which simplifies these procedures.

Assigning a jitter value further advantageously includes weighting a plurality of measured values with a predetermined weighting function. For example, a V-shaped weighting function can be used to shift the optimum towards the middle of the trigger safe area. Usually, this very small weighting has no effect. It is useful when the trigger output signal is near to the ideal one and all potential trigger levels have the same small jitter. In this case any of the trigger levels can be chosen. The best choice in this case is to choose the middle one. With this gentle weighting this is also possible.

A digital signal processing system advantageously comprises means for executing the method of any of the preceding claims.

The advantages achieved by the present invention include the provision of a new trigger level calculation method that is able to determine proper trigger levels automatically from the digitized analog input signal. The trigger level determination is based on jitter measurement on different trigger levels. For the comparison, the measured jitter levels are further processed: filtered, tresholded and weighted to ensure proper trigger selection in extreme cases as well. The accuracy of calculations is improved by using linear interpolation between neighbouring samples around the trigger level to determine trigger times more accurately. Furthermore, the method changes the output only, if the input signal is significantly changed. This behavior is advantageous at phase measurements to avoid additional phase jitter because of trigger level change.

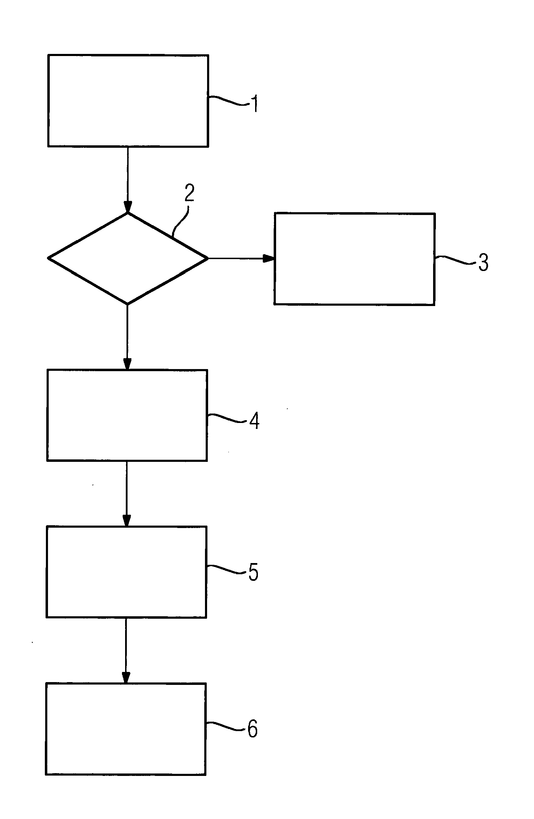

An embodiment of the invention is further explained by means of a figure, wherein the only FIG shows

- a representative block diagram of the method steps to determine a trigger level.

The method according to the embodiment of the FIG requires the following parameters:

- Trigger timeout value, T, from which a measurement update time can be calculated
- "Low voltage" value
- Minimum and maximum "safe area" limits, L1 and L2
- Trigger slope direction, bRisingDirection
- Number of possible trigger levels to be examined, N

The timeout value T is a time interval within which the input signal makes at least one period. Safe area limits are limit numbers given in percent. If the interval between the minimum and maximum value of input signal is 0 - 100%, then minimum and maximum safe area numbers select a smaller interval in which the optimum trigger level can be selected. Trigger slope direction tells, if the trigger level to be determined relates to rising edge (bRisingDirection = TRUE) or falling edge (bRisingDirection = FALSE).

The method consists of the following states:

STATE1: Measuring 1 the minimum and maximum values of the analog input signal. This procedure should last at least T time for observation to be sure that at least one full period passes, hence the real minimum and maximum value appear in the input signal. If ready, the state is changed to STATE2.

STATE2: Determining a peak-to-peak quality number and check if signal level is acceptable. Check 2 also, if the signal level significantly differs compared to the previous extended measurement. If the signal level is not acceptable or the difference is small, then extended measurement is not necessary and the method is interrupted 3. If the difference is sufficient, then determine auxiliary parameters for further observations, particularly define 4 a plurality of potential trigger values between the minimum and maximum values and go further to STATE3. The potential trigger values are evenly spaced.

The pseudocode for this is shown in the following:

STATE2:

```
Quality_P2P = Max-Min;          %determine Peak-to-peak
                                quality number

if ( (Max-Min) < LOW_VOLTAGE )  %level of input signal is
    status = STATE1;            not enough
end;


%determine safe area:
S1 = (Max-Min)*L1/100 + Min;
S2 = (Max-Min)*L2/100 + Min;


%determine hysteresis for trigger examination
```

```
Hyst = (Max-Min)/N;
%determine recommended hysteresis of triggering
Recommended_Hysteresis = 2*Hyst;


if(bRisingDirection)
    Hyst = -Hyst;
end;


%define N+1 trigger levels in the safe area
Diff = (S2-S1)/(N-1);
for(i=0;i<N;i++)
    TrigLevels[i] = S1 + i*Diff;
    HystLevels[i] = TrigLevels[i] + Hyst;
end;


%check if measured new minimum and maximum values are
%significantly differ from the old ones. If the difference
%is smaller than (S2-S1)/(2*N), then change is not
% significant and further examination is not necessary
Diff   = (S2-S1)/(2*N);
Diff1  = abs(S1-S1_old);
Diff2  = abs(S2-S2_old);
S1_old = S1;
S2_old = S2;
if (( Diff1 < Diff ) AND ( Diff2 < Diff ))
    status = STATE1;
else
    status = STATE3;
end;
```

STATE3: performing extended measurement. The length of this extended measurement is 5 times timeout for each trigger level to collect several periods and determine periodlength jitter and average with enough accuracy. This determination can be run parallel on all trigger levels to save measurement time, but also can be run serial to save CPU time. The trigger detection has the following pseudocode:

```
%inputs are
float HystLevel; %actual hysteresis level from HystLevels[]
float Triglevel; %actual trigger level from TrigLevels[]
float x[]; % array of input samples
%auxiliary variables:
int i;
bool bTrigDetect;
```

```
STATE3:
    if(bRisingDirection)
        for i = each_incoming_sample_position
            if( x[i] < HystLevel)
                bTrigDetect = TRUE;
            end;
            if(bTrigDetect AND (x[i]>=TrigLevel))
                bTrigDetect = FALSE;
                calculate_auxiliary_variables(x[i],x[i-1]);
            end;
        end for;
    else
        for i = each_incoming_sample_position
            if( x[i] > HystLevel)
                bTrigDetect = TRUE;
            end;
            if(bTrigDetect AND (x[i]<=TrigLevel))
                bTrigDetect = FALSE;
                calculate_auxiliary_variables(x[i],x[i-1]);
            end;
        end for;
    end;
```

Calculation of auxiliary variables means a recursive regression calculation. It uses linear interpolation to determine the trigger time more accurate:

```
                div = (x[i-1] - x[i]);


    if(div != 0.0f)
    {
        Correction = ((x[i] - TrigLevel) / fdiv);
    }
    else
    {
        Correction = 0.0f;
    }
    Tperiod = Tperiod + Correction;
```

The auxiliary variables for regression calculation are:

- Sy: sum of (actual periodlength value - reference value),
- Syy: sum of square of (actual periodlength value - reference value),
- Sxy: number of actually period counted from measurement start, Cnt, multiplied with (periodlength value - reference value).

The reference value can be the first periodlength value. This helps to keep the sum of numbers small and therefore accurate. Calculation of jitter is the following:

```
float A;   % lin reg. steepness
float B;   % lin reg. offset
float J;   % lin reg. variance
float P;   % inner variable for lin reg calculation
float Q;   % inner variable for lin reg calculation
float R;   % inner variable for lin reg calculation
float S;   % inner variable for lin reg calculation
float Aux; % inner variable for lin reg calculation
float Sx;  % first moment of input
float Sxx; % second moment of input

Sx = (Cnt * (Cnt + 1)) / 2;
Sxx = (Cnt * (Cnt + 1) * ((2 * Cnt) + 1)) / 6;
```

```
Aux = ((Cnt * Sxx) - (Sx * Sx));
if( 0 < Aux )
{
    Aux = 1/Aux;
}
P = Cnt * Aux;
Q = Sx * Aux;
R = 1 / Cnt;
S = Sx * R;


A = (P * Sxy) - (Q * Sy);
B = (R * Sy) - (S * A);


J = (((Syy
        - (2 * B * Sy))
        - (2 * A * Sxy))
        + (Cnt * B * B)
        + (A * A * Sxx)
        + (2 * A * B * Sx));


J /= Cnt;


J = sqrt(abs(J));      %this abs value forming must be done
                       %because of accidental inaccuracies
                       %in the calculations.
                       %Without this, square-rooting of
                       %a negative number can occur.
```

Calculation of the average periodtime can be done simply by adding together the measured periodlength values and at the end divide the sum by Cnt.

STATE4: Evaluating the best trigger level by assigning 5 to the respective potential trigger value a jitter value characteristic for the jitter created by processing the signal with the potential trigger value and then determining 6 the optimal trigger level based on the lowest jitter value. In the described embodiment, this is not simply the level with the lowest measured jitter because for example selection is not possible or not the best if the jitter is the same or almost the same on all potential trigger levels. Therefore the "best trigger level" is found as follows:

- As the first step, a sliding average on the jitter vector can be done. At fine trigger level resolution this method can help to keep distance from trigger parts, where the jitter suddenly increases. However, when the trigger level resolution is rough (e.g. only 5 levels) this step is unnecessary.

- As the next step of trigger position finding, a threshold level on the jitter values is used. If the jitter at a given trigger band is lower than this value, then it is accepted as a "very good jitter level", regardless to its exact value and replaced by the threshold level. This means that in the following procedures, these low jitter levels will be handled uniformly. In the embodiment, the threshold level is 0.04 samples.

- The next step is the jitter weighting. The weighting method in the embodiment is the use of a V-shaped weighting vector to shift the optimum towards the middle of the trigger safe area. This weighting vector has 0.9 weighting at the middle and 1.0 weighting at the edges. Usually, this very small weighting has no effect. It is useful only when the trigger signal is near to the ideal one and all trigger bands have the same small jitter. In this case one can choose any of the trigger bands. The best choice in this case is to choose the middle one. With this gentle weighting this is also possible.

- The last step of trigger finding is to select the smallest weighted jitter output. With this one can find the best trigger level and the better trigger direction. This output corresponds to the purposes: at the selected trigger band and direction the jitter is acceptably low and the jitter will remain also low, if there are smaller changes in the trigger signal.

The method can also calculate the following trigger quality numbers:

- absJitter: the absolute value of the jitter measured at the recommended trigger band and trigger direction. The jitter is defined as the non-corrected standard deviation of the measured periodlength values:

$$j = \sqrt{\frac{1}{N} \sum_{k=1}^{N} (T_{k,bestband} - T_{avgperiod})^2}$$

If this value is higher than $2\mu\text{sec}$, the block must sign that the output is not OK. (The periodlength parameters are calculated with linear interpolation to make accurate jitter measurements.)

- minJitter: jitter in percent relative to the periodlength measured at the recommended trigger band and direction.

- trigQ1: ratio of the average jitter of all bands and minJitter:

$$trigQ1 = \frac{j_{best}}{\frac{1}{5} \sum_{i=1}^{5} j_i}$$

If this number is around one, this means that the jitter is small everywhere in the safe trigger area. This is the behavior of the ideal trigger signal. If this value is high, this means that certain signal parts are not recommended for triggering that could be a problem if the trigger signal amplitude changes.

- trigQ2: absolute value of the difference of the periodlength measured at the recommended trigger band and the average periodlength of all bands, relative to the periodlength measured at recommended trigger:

$$trigQ2 = \frac{T_{best} - \frac{1}{5} \sum_{i=1}^{5} T_i}{T_{best}} \cdot 100\%$$

If this number is around 0, this means that the measured periodlength is the same everywhere, which is the ideal case. If the difference is high, then different periodlength values can be measured at different trigger bands. The reason for this could be high jitter, or extra, unwanted, low amplitude impulses in the input signal.

- Trigger signal Peak-to-Peak value. The higher the better.

Thus, the method according to the embodiment determines quality numbers about the goodness of trigger. These are signal peak-to-peak, absolute jitter value, relative jitter value (relative to periodlength), ratio of jitter of chosen trigger level and average jitter in all examined trigger bands, ratio of periodlength if chosen trigger level and average periodlength in all examined trigger bands. These quality numbers can be checked by the user and used to make decisions.

All steps described above are executed automatically by a processing unit in a digital signal processing system.

List of reference numerals

1    Measuring the minimum and maximum values of the signal
2    Checking if the difference of the measured minimum and maximum values of the signal differ from the minimum and maximum values measured during a previous execution of the method
3    Interrupting execution
4    Defining a plurality of potential trigger values
5    Assigning to the respective potential trigger value a jitter value characteristic for the jitter created by processing the signal with the potential trigger value
6    determining the optimal trigger level based on the lowest jitter value

**Claims**

1.  A method for determining a trigger level for a periodic analog signal in a digital signal processing system, comprising the steps of:

    - measuring (1) the minimum and maximum values of the signal in a predetermined time,
    - defining (4) a plurality of potential trigger values between the minimum and maximum values,
    - assigning (5) to the respective potential trigger value a jitter value characteristic for the jitter created by processing the signal with the potential trigger value, and
    - determining (6) the optimal trigger level based on the lowest jitter value.

2.  The method of claim 1, wherein the predetermined time is longer than the period of the signal.

3.  The method of any of the preceding claims, wherein the potential trigger values are evenly spaced.

4.  The method of any of the preceding claims, wherein execution of the method is interrupted (3) if the difference of the measured minimum and maximum values of the signal differ from the minimum and maximum values measured during a previous execution of the method by less than a predetermined value.

5.  The method of any of the preceding claims, wherein the jitter created by processing the signal is determined by means of a linear regression over a plurality of periods of the signal.

6.  The method of claim 5, wherein the plurality of periods is 5 or more.

7.  The method of any of the preceding claims, wherein assigning (5) a jitter value includes taking a sliding average over a plurality of trigger values.

8.  The method of any of the preceding claims, wherein assigning (5) a jitter value includes replacing a measured value with a predetermined threshold value.

9.  The method of any of the preceding claims, wherein assigning (5) a jitter value includes weighting a plurality of measured values with a predetermined weighting function.

10. A digital signal processing system with means for executing the method of any of the preceding claims.

**Patentansprüche**

1. Verfahren zum Bestimmen eines Auslösepegels für ein periodisches analoges Signal in einem digitalen Signalverarbeitungssystem, das die folgenden Schritte umfasst:

   - Messen (1) der kleinsten und größten Werte des Signals in einer vorbestimmten Zeit,
   - Definieren (4) mehrerer potentieller Auslösewerte zwischen den kleinsten und den größten Werten,
   - Zuweisen (5) zu dem jeweiligen potentiellen Auslösewert eines Jitter-Werts, der charakteristisch für den Jitter ist, der durch das Verarbeiten des Signals mit dem potentiellen Auslösewert erzeugt wird, und
   - Bestimmen (6) des optimalen Auslösepegels basierend auf dem niedrigsten Jitter-Wert.

2. Verfahren nach Anspruch 1, wobei die vorbestimmte Zeit länger als die Periode des Signals ist.

3. Verfahren nach einem der vorhergehenden Ansprüche, wobei die potentiellen Auslösewerte gleichmäßige Abstände aufweisen.

4. Verfahren nach einem der vorhergehenden Ansprüche, wobei das Ausführen des Verfahrens unterbrochen wird (3), falls sich die Differenz der gemessenen kleinsten und größten Werte des Signals von den kleinsten und größten Werten, die während einer vorhergehenden Ausführung des Verfahrens gemessen wurden, um weniger als einen vorbestimmten Wert unterscheidet.

5. Verfahren nach einem der vorhergehenden Ansprüche, wobei der Jitter, der durch Verarbeiten des Signals erzeugt wird, mit Hilfe einer linearen Regression über mehrere Perioden des Signals bestimmt wird.

6. Verfahren nach Anspruch 5, wobei die Pluralität der Perioden 5 oder größer ist.

7. Verfahren nach einem der vorhergehenden Ansprüche, wobei das Zuweisen (5) eines Jitter-Werts das Nehmen eines gleitenden Durchschnitts über mehrere Auslösewerte enthält.

8. Verfahren nach einem der vorhergehenden Ansprüche, wobei das Zuweisen (5) eines Jitter-Werts das Ersetzen eines gemessenen Werts durch einen vorbestimmten Schwellenwert enthält.

9. Verfahren nach einem der vorhergehenden Ansprüche, wobei das Zuweisen (5) eines Jitter-Werts das Gewichten von mehreren gemessenen Werten mit einer vorbestimmten Gewichtungsfunktion enthält.

10. Digitales Signalverarbeitungssystem mit Mitteln zum Ausführen des Verfahrens nach einem der vorhergehenden Ansprüche.

**Revendications**

1. Procédé de détermination d'un niveau de déclenchement d'un signal analogique périodique dans un système de traitement numérique du signal, comprenant les stades dans lesquels :

   - on mesure ( 1 ) les valeurs minimum et maximum du signal dans un temps déterminé à l'avance,
   - on définit ( 4 ) une pluralité de valeurs potentielles de déclenchement entre les valeurs minimum et maximum,
   - on affecte ( 5 ) à la valeur potentielle respective de déclenchement une valeur de gigue caractéristique de la gigue créée en traitant le signal par la valeur potentielle de déclenchement et
   - on détermine ( 6 ) le niveau optimum de déclenchement sur la base de la valeur de gigue la plus petite.

2. Procédé suivant la revendication 1, dans lequel le temps déterminé à l'avance est plus long que la période du signal.

3. Procédé suivant l'une quelconque des revendications précédentes, dans lequel les valeurs potentielles de déclenchement sont espacées régulièrement.

4. Procédé suivant l'une quelconque des revendications précédentes, dans lequel on interrompt ( 3 ) l'exécution du procédé si la différence des valeurs mesurées de minimum et de maximum du signal diffère des valeurs minimum et maximum mesurées pendant une exécution précédente du procédé de moins d'une valeur déterminée à l'avance.

**5.** Procédé suivant l'une quelconque des revendications précédentes, dans lequel on détermine la gigue créée en traitant le signal au moyen d'une régression linéaire sur une pluralité de périodes du signal.

**6.** Procédé suivant la revendication 5, dans lequel la pluralité de périodes est supérieure ou égale à 5.

**7.** Procédé suivant l'une quelconque des revendications précédentes, dans lequel affecter ( 5 ) une valeur de gigue comprend prendre une moyenne mobile sur d'une pluralité de valeurs de déclenchement.

**8.** Procédé suivant l'une quelconque des revendications précédentes, dans lequel affecter ( 5 ) une valeur de gigue comprend remplacer une valeur mesurée par une valeur de seuil déterminée à l'avance.

**9.** Procédé suivant l'une quelconque des revendications précédentes, dans lequel affecter ( 5 ) une valeur de gigue comprend pondérer une pluralité de valeurs mesurées par une fonction de pondération déterminée à l'avance.

**10.** Système de traitement numérique du signal ayant des moyens pour exécuter le procédé suivant l'une quelconque des revendications précédentes.

**EP 2 651 034 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4743844 A